# EUROPEAN PATENT APPLICATION

(11) **EP 4 716 430 A1**
(43) Date of publication of application: **25.03.2026**
(21) Application number: 24824978.1
(22) Date of filing: 09.04.2024
(51) Int. Cl.: H10K 30/40, H10K 30/50

(54) **PEROVSKITE THIN FILM AND PREPARATION METHOD THEREFOR, PEROVSKITE CELL AND ELECTRIC DEVICE**

(30) Priority: 21.06.2023 CN 202310753062
(71) Applicant: Contemporary Amperex Future Energy Research Institute (Shanghai) Limited, Shanghai 200241 (CN); Contemporary Amperex Technology Co., Limited, Ningde, Fujian 352100 (CN)
(72) Inventor: JIA, Boyu, Shanghai 200241 (CN); YIN, Zhaoyi, Shanghai 200241 (CN); AN, Xinyi, Shanghai 200241 (CN); GU, Shuai, Shanghai 200241 (CN); CHEN, Chen, Shanghai 200241 (CN); LIU, Tianyu, Shanghai 200241 (CN); ZHENG, Yi, Shanghai 200241 (CN); YE, Jianing, Shanghai 200241 (CN); CHEN, Junchao, Shanghai 200241 (CN); CHEN, Guodong, Shanghai 200241 (CN); GUO, Yongsheng, Shanghai 200241 (CN)
(74) Representative: Gong, Jinping
(86) International application number: PCT/CN2024/086842
(87) International publication number: WO 2024/260076

(57) **Abstract**

A perovskite film and a preparation method thereof, a perovskite battery, and an electric apparatus are provided. The perovskite film includes: a perovskite matrix layer; and a plurality of spaced-apart nano-protrusions disposed on at least one surface of the perovskite matrix layer.

## Description

### CROSS-REFERENCE TO RELATED APPLICATIONS

The present application incorporates by reference in its entirety Chinese Patent Application No. 202310753062.9, filed on June 21, 2023, entitled "PEROVSKITE FILM AND PREPARATION METHOD THEREOF, PEROVSKITE BATTERY, AND ELECTRIC APPARATUS".

### TECHNICAL FIELD

The present application relates to the field of solar cell technology, and more particularly, to a perovskite film and a preparation method thereof, a perovskite battery, and an electric apparatus.

### BACKGROUND

The statements herein merely provide background information related to the present application and do not necessarily constitute prior art.

Perovskite solar cells (perovskite solar cells) are apparatuses that utilize the photoelectric conversion mechanism of perovskite-type crystal materials to convert solar energy into electrical energy, representing the third generation of solar cells. Perovskite solar cells possess advantages such as high photoelectric conversion efficiency, simple manufacturing processes, and low production costs, and have been extensively studied in recent years. Despite these advantages, there remains a certain gap to the commercial large-scale application of perovskite batteries, with one of the key issues to be addressed being the enhancement of the photoelectric conversion efficiency of perovskite batteries.

### SUMMARY

In view of the above issues, the present application provides a perovskite film and a preparation method thereof, a perovskite battery, and an electric apparatus, where the perovskite film is configured to enhance the photoelectric conversion efficiency of the perovskite battery.

According to a first aspect, the present application provides a perovskite film, including: a perovskite matrix layer; and a plurality of spaced-apart nano-protrusions disposed on at least one surface of the perovskite matrix layer.

The perovskite film provided by the present application includes a perovskite matrix layer and a plurality of spaced-apart nano-protrusions disposed thereon. The nano-protrusions enable point contact at an interface between the perovskite film and an adjacent charge transport layer, thereby reducing a contact area between the perovskite film and the charge transport layer interface, decreasing contact at the interface between the perovskite film and the charge transport layer, reducing occurrence of non-radiative recombination due to interface contact, and enhancing open-circuit voltage and photoelectric conversion efficiency.

In some embodiments, an average particle size of the nano-protrusions is from 1 nanometer (nm) to 10 nm, optionally from 1 nm to 5 nm.

The average particle size of the nano-protrusions being within the above range facilitates sufficient point contact at the interface between the perovskite film and the adjacent charge transport layer, sufficiently reducing occurrence of non-radiative recombination due to interface contact, and enhancing open-circuit voltage and photoelectric conversion efficiency.

In some embodiments, a spacing distance between center points of two adjacent nano-protrusions is from 2 nm to 1 micrometer (µm), optionally from 10 nm to 0.5 µm.

The spacing distance between center points of two adjacent nano-protrusions being within the above range helps to increase a density of the nano-protrusions on the perovskite film, thereby further reducing a contact area between the perovskite film and the charge transport layer, reducing occurrence of non-radiative recombination due to interface contact, and further enhancing open-circuit voltage and photoelectric conversion efficiency.

In some embodiments, the nano-protrusions satisfy at least one of the following conditions:
(1) the nano-protrusions have an irregular columnar morphology; and
(2) a chemical composition of the nano-protrusions includes LₘAₙ₋₁BₙX₃ₙ₊₁, where 1 ≤ m ≤ 2, n ≥ 1 and is an integer, L ion is NH₄⁺, A ion is a monovalent cation, B ion is a divalent metal cation, C ion and D ion are a monovalent metal cation and a trivalent metal cation, respectively, and X ion is a monovalent anion;

the A ion includes one or more of an organic cation, Li⁺, Na⁺, K⁺, Rb⁺, and Cs⁺;
optionally, the organic cation includes at least one of an organic amine ion, a formamidinium group, and an imidazolium group;
further optionally, the organic amine ion includes at least one of a methylamine group, an ethylamine group, a propylamine group, a butylamine group, a pentylamine group, and a hexylamine group;
optionally, the A ion includes one or more of an organic amine ion and Cs⁺;
the B ion includes one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, Cu²⁺, and Ni²⁺;
optionally, the B ion includes one or both of Pb²⁺ and Sn²⁺;
the C ion includes one or more of Cs⁺, Ag⁺, K⁺, and Ru⁺;
the D ion includes one or more of Bi³⁺, Ni³⁺, Fe³⁺, and Cu³⁺;
the X ion includes one or more of F⁻, Cl⁻, Br⁻, and I⁻; and
optionally, the X ion includes one or more of Cl⁻, Br⁻, and I⁻.

The nano-protrusions have the irregular columnar morphology, and the irregular columnar morphology further promotes point contact at the interface between the perovskite film and the adjacent charge transport layer, further reducing occurrence of non-radiative recombination due to interface contact, thereby enhancing open-circuit voltage and photoelectric conversion efficiency.

In some embodiments, the perovskite matrix layer satisfies at least one of the following conditions:
(1) a thickness of the perovskite matrix layer is from 100 nm to 1000 nm, optionally from 500 nm to 800 nm; and
(2) a chemical composition of the perovskite matrix layer includes a compound ABX₃ or A₂CDX₆, where A ion is a monovalent cation, B ion is a divalent metal cation, C ion and D ion are a monovalent metal cation and a trivalent metal cation, respectively, and X ion is a monovalent anion;

the A ion includes one or more of an organic cation, Li⁺, Na⁺, K⁺, Rb⁺, and Cs⁺;
optionally, the organic cation includes at least one of an organic amine ion, a formamidinium group, and an imidazolium group;
further optionally, the organic amine ion includes at least one of a methylamine group, an ethylamine group, a propylamine group, a butylamine group, a pentylamine group, and a hexylamine group;
optionally, the A ion includes one or more of an organic amine ion and Cs⁺;
the B ion includes one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, Cu²⁺, and Ni²⁺;
optionally, the B ion includes one or both of Pb²⁺ and Sn²⁺;
the C ion includes one or more of Cs⁺, Ag⁺, K⁺, and Ru⁺;
the D ion includes one or more of Bi³⁺, Ni³⁺, Fe³⁺, and Cu³⁺;
the X ion includes one or more of F⁻, Cl⁻, Br⁻, and I⁻;
optionally, the X ion includes one or more of Cl⁻, Br⁻, and I⁻; and
optionally, the chemical composition of the perovskite matrix layer includes an organic halide CsₓFA_{y}MA_{z}PbI₃, where x+y+z=1, 0≤x≤0.05, 0.8≤y≤0.95, and 0≤z≤0.1.

The thickness of the perovskite matrix layer being within the above range helps to further promote its light absorption function.

According to a second aspect, the present application provides a preparation method of a perovskite film, including:
preparing a perovskite matrix layer on a support layer; and
enabling an ammonium salt solution to come into contact with a surface of the perovskite matrix layer and performing a first annealing treatment to form a plurality of spaced-apart nano-protrusions on the surface of the perovskite matrix layer, forming a perovskite composite, and obtaining the perovskite film.

The method provided by the present application enables preparation of nano-protrusions through a simple chemical reaction between the ammonium salt and the perovskite matrix layer and a simple annealing treatment, without requiring the introduction of other complex processes (such as mask processes), thereby facilitating reduction of process complexity in device manufacturing and significantly lowering production costs in large-scale commercial production.

In some embodiments, the ammonium salt solution satisfies at least one of the following conditions:
(1) a mass concentration of the ammonium salt solution is from 0.05 milligrams per milliliter (mg/mL) to 1 mg/mL;
(2) the ammonium salt includes one or more of ethylenediamine, propylenediamine, butylenediamine, and p-phenylenediamine; and
(3) the ammonium salt solution includes a first organic solvent, the first organic solvent including one or more of isopropanol, ethanol, ethylene glycol, and glycerol.

The mass concentration of the ammonium salt solution being within the above range helps to promote a reaction between the ammonium salt and chemical compositions in the perovskite matrix layer to form zero-dimensional perovskite, thereby promoting formation of crystal nuclei.

In some embodiments, the first annealing treatment satisfies at least one of the following conditions:
(1) a temperature of the first annealing treatment is from 90 degrees Celsius (°C) to 120°C; and
(2) a duration of the first annealing treatment is from 5 minutes (min) to 10 min.

The temperature and duration of the first annealing treatment being within the above ranges help to promote growth of the nano-protrusions in an island growth mode.

In some embodiments, the method further includes: performing an impurity removal treatment on the perovskite composite.

In some embodiments, the step of performing the impurity removal treatment on the perovskite composite includes:
enabling a second organic solvent to come into contact with a surface of the perovskite composite and performing a second annealing treatment;
optionally, the second organic solvent includes one or more of isopropanol, ethanol, ethylene glycol, and glycerol;
optionally, a temperature of the second annealing treatment is from 90°C to 120°C; and
optionally, a duration of the second annealing treatment is from 5 min to 10 min.

In the above steps, cleaning the surface of the perovskite composite with the second organic solvent enables relatively complete dissolution of impurities in the second organic solvent; and subsequently performing the second annealing treatment enables relatively complete removal of the impurities.

In some embodiments, the step of preparing the perovskite matrix layer on the support layer includes:
enabling a perovskite precursor solution to come into contact with an anti-solvent on the support layer to form a wet film of the perovskite matrix layer; and
performing a third annealing treatment on the wet film of the perovskite matrix layer to obtain the perovskite matrix layer; where
optionally, a temperature of the third annealing treatment is from 90°C to 150°C; and
optionally, a duration of the third annealing treatment is from 10 min to 40 min.

In the above steps, treating the perovskite precursor solution with the anti-solvent helps to enhance crystallinity of the perovskite matrix layer at room temperature; and subsequently performing the third annealing treatment helps to further promote crystal growth of the perovskite matrix layer and removal of residual anti-solvent.

In some embodiments, the method satisfies at least one of the following conditions:
(1) the perovskite precursor solution includes a compound ABX₃ or A₂CDX₆, where A ion is a monovalent cation, B ion is a divalent metal cation, C ion and D ion are a monovalent metal cation and a trivalent metal cation, respectively, and X ion is a monovalent anion;
   the A ion includes one or more of an organic cation, Li⁺, Na⁺, K⁺, Rb⁺, and Cs⁺;
   optionally, the organic cation includes at least one of an organic amine ion, a formamidinium group, and an imidazolium group;
   further optionally, the organic amine ion includes at least one of a methylamine group, an ethylamine group, a propylamine group, a butylamine group, a pentylamine group, and a hexylamine group;
   optionally, the A ion includes one or more of an organic amine ion and Cs⁺;
   the B ion includes one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, Cu²⁺, and Ni²⁺;
   optionally, the B ion includes one or both of Pb²⁺ and Sn²⁺;
   the C ion includes one or more of Cs⁺, Ag⁺, K⁺, and Ru⁺;
   the D ion includes one or more of Bi³⁺, Ni³⁺, Fe³⁺, and Cu³⁺;
   the X ion includes one or more of F⁻, Cl⁻, Br⁻, and I⁻;
   optionally, the X ion includes one or more of Cl⁻, Br⁻, and I⁻; and
   optionally, the perovskite precursor solution includes an organic halide CsₓFA_{y}MA_{z}PbI₃, where x+y+z=1, 0≤x≤0.05, 0.8≤y≤0.95, and 0≤z≤0.1;
(2) a molar concentration of the perovskite precursor solution is from 1 mole per liter (mol/L) to 1.8 mol/L; and
(3) the anti-solvent includes one or more of chlorobenzene, anisole, diethyl ether, and ethyl acetate.

The molar concentration of the perovskite precursor solution being within the above range enables provision of sufficient organic luminescent material for the perovskite matrix layer, thereby providing sufficient photoelectrons, resulting in a relatively high luminescence efficiency (photoelectric conversion efficiency) of the perovskite battery.

According to a third aspect, the present application provides a perovskite battery including the perovskite film according to the first aspect of the present application or the perovskite film prepared by the method according to the second aspect of the present application.

In some embodiments, the perovskite film includes a first electrode layer, a perovskite layer, a first charge transport layer, and a second electrode layer stacked sequentially, the perovskite layer including the perovskite film, where the nano-protrusions in the perovskite film face the first charge transport layer along a thickness direction of the perovskite layer.

The perovskite battery provided by the present application includes the aforementioned perovskite film, the nano-protrusions in the perovskite film face the first charge transport layer, and the nano-protrusions enable point contact at an interface between the perovskite layer and the first charge transport layer, thereby reducing a contact area between the perovskite layer and the first charge transport layer. This reduces occurrence of non-radiative recombination due to interface contact, thus enhancing the open-circuit voltage and photoelectric conversion efficiency of the battery.

In some embodiments, the first charge transport layer includes a first charge transport matrix layer and a filler disposed on a surface of the first charge transport matrix layer, the filler extending along a thickness direction of the first charge transport matrix layer and filling gaps formed by the nano-protrusions;
optionally, the first charge transport layer includes an electron transport layer; and
optionally, the first charge transport matrix layer and the filler have the same chemical composition.

In some embodiments, the perovskite battery further includes a second charge transport layer, where the second charge transport layer is disposed between the first electrode layer and the perovskite layer; and
optionally, the second charge transport layer includes a hole transport layer.

The first charge transport layer includes the filler formed by filling gaps formed by the nano-protrusions, and the filler can achieve point contact between the first charge transport layer and the perovskite layer. By controlling the spacing distance between the nano-protrusions, a number of gaps formed by the nano-protrusions per unit area of the perovskite layer can be controlled, thereby controlling a density of the filler. By controlling the density of the filler, a filling amount of the first charge transport layer can be controlled, thereby controlling a contact area between the first charge transport layer and the perovskite layer, sufficiently reducing occurrence of non-radiative recombination between the two, and effectively enhancing the open-circuit voltage and photoelectric conversion efficiency of the battery.

According to a fourth aspect, the present application provides an electric apparatus including the perovskite battery according to the third aspect.

Details of one or more embodiments of the present application are set forth in the accompanying drawings and the description below. Other features, purposes, and advantages of the present application become apparent from the specification, the accompanying drawings, and the claims.

### BRIEF DESCRIPTION OF THE DRAWINGS

To illustrate the technical solutions of the embodiments of the present application more clearly, the drawings required for use in the embodiments of the present application are briefly described below. It is apparent that the drawings described below are merely some embodiments of the present application, and those of ordinary skill in the art can obtain other drawings based on these drawings without creative effort. In the accompanying drawings:
FIG. 1 is a schematic structural diagram of a perovskite film according to an embodiment of the present application.
FIG. 2 is a schematic structural diagram of a perovskite battery according to an embodiment of the present application.
FIG. 3 is a schematic structural diagram of a perovskite battery according to another embodiment of the present application.
FIG. 4 is a schematic structural diagram of a perovskite battery according to still another embodiment of the present application.
FIG. 5 is a schematic diagram of an electric apparatus using a perovskite battery as a power source according to an embodiment of the present application.
FIG. 6 is a surface morphology diagram of a perovskite film according to an embodiment of the present application.

Description of reference signs: 10. first electrode; 20. second charge transport layer; 30. perovskite layer; 40. first charge transport layer; 50. second electrode layer; 310. perovskite matrix layer; 320. nano-protrusions; 410. first charge transport matrix layer; and 420. filler.

### DESCRIPTION OF EMBODIMENTS

Hereinafter, some embodiments disclosing a perovskite film and a preparation method thereof, a perovskite battery, and an electric apparatus of the present application are described in detail with appropriate reference to the drawings. However, unnecessary detailed descriptions may be omitted. For example, detailed descriptions of well-known matters or redundant descriptions of substantially identical structures may be omitted. This is to avoid unnecessary verbosity in the following description and to facilitate understanding by those skilled in the art. Additionally, the drawings and the following description are provided for those skilled in the art to fully understand the present application and are not intended to limit the subject matter recited in the claims.

"Ranges" disclosed in the present application are defined in the form of lower and upper limits. A given range is defined by selecting one lower limit and one upper limit, where the selected lower and upper limits define boundaries of that special range. Ranges defined in this manner may include or exclude endpoints and can be arbitrarily combined, that is, any lower limit can be combined with any upper limit to form a range. For example, if ranges of 60-120 and 80-110 are listed for a specific parameter, it is understood that ranges of 60-110 and 80-120 are also contemplated. Additionally, if minimum range values of 1 and 2 are listed, and maximum range values of 3, 4, and 5 are listed, the following ranges are all contemplated: 1-3, 1-4, 1-5, 2-3, 2-4, and 2-5. In the present application, unless otherwise specified, a numerical range "a-b" represents an abbreviated representation of any real number combination between a and b, where both a and b are real numbers. For example, the numerical range "0-5" indicates that all real numbers between "0-5" have been listed herein, and "0-5" is merely an abbreviated representation of these numerical combinations. Additionally, a parameter expressed as an integer greater than or equal to 2 is equivalent to disclosing that the parameter is, for example, an integer among 2, 3, 4, 5, 6, 7, 8, 9, 10, 11, 12, and so on. For example, a parameter expressed as an integer selected from "2-10" is equivalent to listing integers of 2, 3, 4, 5, 6, 7, 8, 9, and 10.

Unless otherwise specified, all embodiments and optional embodiments of the present application can be combined with each other to form new technical solutions.

Unless otherwise specified, all steps of the present application may be performed sequentially or randomly, preferably sequentially. For example, a method including steps (a) and (b) indicates that the method may include steps (a) and (b) performed in order or may include steps (b) and (a) performed in order. For example, the foregoing method may further include step (c), which indicates that step (c) may be added to the method in any ordinal position, for example, the method may include steps (a), (b), and (c), steps (a), (c), and (b), steps (c), (a), and (b), or the like.

Unless otherwise specified, the terms "include", "contain", and "comprise" mentioned in the present application indicate an open-ended or closed-ended form. For an open-ended form, "include", "contain", and "comprise" may indicate that other unlisted members, elements, or method steps may also be included or contained, or may indicate that only the listed members, elements, or method steps are included or contained.

Unless otherwise specified, in the present application, the term "or" is inclusive. For example, the phrase "A or B" means "A, B, or both A and B". Further, any one of the following conditions satisfies the condition "A or B": A is true (or present) and B is false (or not present); A is false (or not present) and B is true (or present); or both A and B are true (or present).

In the present application, unless otherwise specified, A (for example, B) indicates that B is a non-limiting example of A, and it can be understood that A is not limited to B.

In the present application, unless specifically specified, terms such as "a plurality of" and "multiple" refer to a quantity greater than or equal to 2. For example, "one or more" means one or more than or equal to two.

In the present application, in terms such as "first aspect", "second aspect", "third aspect", "fourth aspect", the terms "first", "second", "third", "fourth", and the like are used solely for descriptive purposes and should not be construed as indicating or implying relative importance or quantity, nor should they be construed as implicitly indicating the importance or quantity of the indicated technical features. Moreover, it should be understood that "first", "second", "third", "fourth", and the like are merely for the purpose of non-exhaustive enumeration and description and should not be understood as any closed limitation on the quantity.

In the present application, when a unit is related to a data range, if the unit is only provided after the right endpoint, it indicates that the units for both the left and right endpoints are the same. For example, 3 to 5 hours (h) or 3-5 h both indicate that the units for the left endpoint "3" and the right endpoint "5" are h (hours).

In a perovskite battery, at an interface between a perovskite layer and an electron transport layer, severe interface defects are typically present, which cause holes on the perovskite surface to undergo severe non-radiative recombination with electrons extracted in the electron transport layer, leading to open-circuit voltage loss and affecting device efficiency. Therefore, a passivation layer is usually introduced to reduce non-radiative recombination and enhance the open-circuit voltage of the device. However, commonly used passivation layers are generally insulating materials, which affect charge transport and reduce the short-circuit current density of the device.

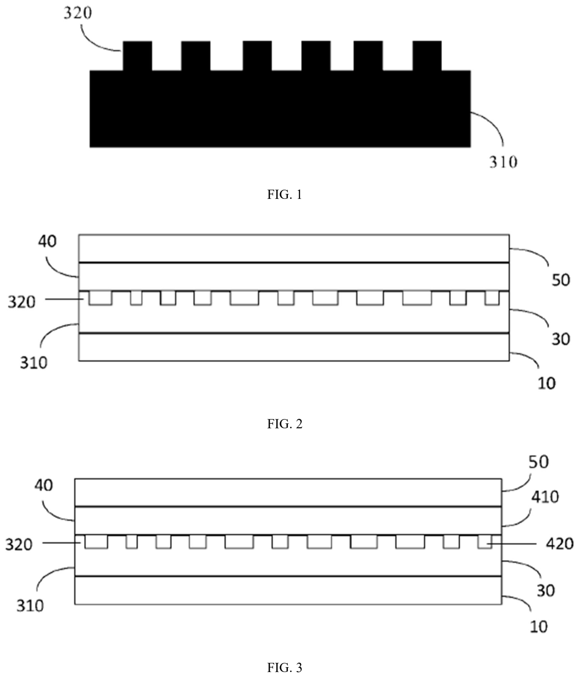

Based on this, according to a first aspect, the present application provides a perovskite film, as shown in FIG. 1, including a perovskite matrix layer 310 and a plurality of spaced-apart nano-protrusions 320 disposed on at least one surface of the perovskite matrix layer 310.

The perovskite film provided by the present application includes a perovskite matrix layer and a plurality of spaced-apart nano-protrusions disposed thereon. When the perovskite film is used in a perovskite battery, the perovskite matrix layer serves as a main layer of the perovskite film, primarily responsible for light absorption function and conversion of light energy into electrical energy. The plurality of spaced-apart nano-protrusions disposed on the surface of the perovskite matrix layer enable point contact at an interface between the perovskite film and an adjacent charge transport layer, thereby reducing a contact area between the perovskite film and the charge transport layer interface, decreasing contact at the interface between the perovskite film and the charge transport layer, reducing occurrence of non-radiative recombination due to interface contact, and enhancing open-circuit voltage and photoelectric conversion efficiency.

Meanwhile, after the use of the above perovskite film in a perovskite battery, there is no need to additionally introduce an insulating passivation layer to reduce non-radiative recombination at the interface between the perovskite layer and the charge transport layer, and charges can be transported through the plurality of nano-protrusions, thereby facilitating enhancement of short-circuit current density compared to introducing an insulating passivation layer.

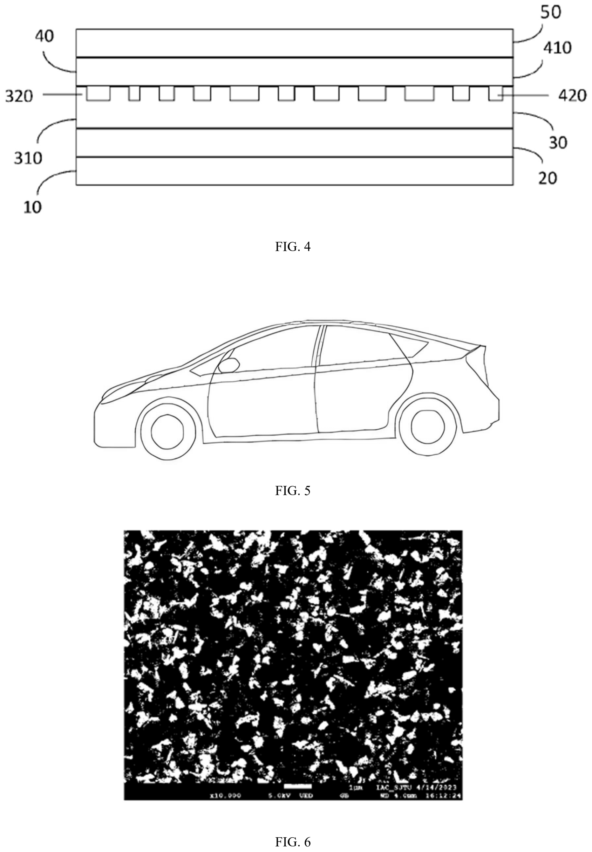

In some embodiments, an average particle size of the nano-protrusions (corresponding to white bright spots in FIG. 6) is from 1 nm to 10 nm. For example, the average particle size of the nano-protrusions may be 1 nm, 2 nm, 3 nm, 4 nm, 5 nm, 6 nm, 7 nm, 8 nm, 9 nm, 10 nm, or within a range formed by any two of these values. Optionally, the average particle size is from 1 nm to 5 nm.

It can be understood that the nano-protrusions of the present application are discontinuously and randomly distributed on the perovskite matrix layer.

In the present application, unless otherwise specified, the average particle size of the nano-protrusions refers to an average value of particle sizes of the nano-protrusions contained per unit area of the perovskite film. The particle size of the nano-protrusions may be measured using methods known in the art. For example, measurement may be performed using an atomic force microscope (Oxford Instruments, model Cypher VRS).

The average particle size of the nano-protrusions being within the above range facilitates sufficient realization of point contact at the interface between the perovskite film and the adjacent charge transport layer, sufficiently reducing a contact area between the perovskite film and the charge transport layer interface, decreasing contact at the interface between the perovskite film and the charge transport layer, sufficiently reducing occurrence of non-radiative recombination due to interface contact, and enhancing open-circuit voltage and photoelectric conversion efficiency.

In some embodiments, a spacing distance between center points of two adjacent nano-protrusions is from 2 nm to 1 µm. For example, the spacing distance between center points of two adjacent nano-protrusions may be 2 nm, 5 nm, 10 nm, 50 nm, 0.1 µm, 0.2 µm, 0.3 µm, 0.4 µm, 0.5 µm, 0.6 µm, 0.7 µm, 0.8 µm, 0.9 µm, 1 µm, or within a range formed by any two of these values. Optionally, the spacing distance is from 10 nm to 0.5 µm.

In the present application, the center point of a nano-protrusion refers to a center position of a projection formed by the nano-protrusion on a film surface of the perovskite film, and the spacing distance between center points of two adjacent nano-protrusions refers to a distance between center positions of projections formed by two adjacent nano-protrusions on the film surface of the perovskite film, which may be measured using methods known in the art. For example, measurement can be performed using a scanning electron microscope (Hitachi, model HD-2700).

The spacing distance between center points of two adjacent nano-protrusions being within the above range helps to increase a number of nano-protrusions per unit area of the perovskite film, that is, increasing a density of the nano-protrusions on the perovskite film. An increase in the density of nano-particles on the perovskite film helps to increase a number of point contacts at the interface between the perovskite film and the charge transport layer, thereby further reducing a contact area between the two, reducing occurrence of non-radiative recombination due to interface contact, and further enhancing open-circuit voltage and photoelectric conversion efficiency.

In the present application, by coordinating the average particle size of the nano-protrusions with the spacing distance between their center points, contact at the interface between the perovskite film and the charge transport layer is controlled, enabling partial contact between the charge transport layer and the perovskite film, thereby sufficiently reducing interface contact between the two without affecting charge transport of the perovskite film, reducing occurrence of non-radiative recombination due to interface contact, and enhancing open-circuit voltage and photoelectric conversion efficiency.

In some embodiments, the nano-protrusions have an irregular columnar morphology.

It can be understood that the "irregular columnar" described in the present application refers to a morphology of the nano-protrusions that is similar to columnar but not completely regular. For example, any cross-section along an axial direction may have a cross-sectional area that is not completely consistent.

The nano-protrusions have the irregular columnar morphology, and the irregular columnar morphology further promotes point contact at the interface between the perovskite film and the adjacent charge transport layer, further reducing occurrence of non-radiative recombination due to interface contact, thereby enhancing open-circuit voltage and photoelectric conversion efficiency.

In some embodiments, a chemical composition of the nano-protrusions includes LₘAₙ₋₁BₙX₃ₙ₊₁, where 1 ≤ m ≤ 2, n ≥ 1 and is an integer, L ion is NH₄⁺, A ion is a monovalent cation, B ion is a divalent metal cation, C ion and D ion are a monovalent metal cation and a trivalent metal cation, respectively, and X ion is a monovalent anion.

In some embodiments, the A ion includes one or more of an organic cation, Li⁺, Na⁺, K⁺, Rb⁺, and Cs⁺.

In some embodiments, the organic cation includes at least one of an organic amine ion, a formamidinium group, and an imidazolium group.

In some embodiments, the organic amine ion includes at least one of a methylamine group, an ethylamine group, a propylamine group, a butylamine group, a pentylamine group, and a hexylamine group.

Optionally, the A ion includes one or more of an organic amine ion and Cs⁺.

In some embodiments, the B ion includes one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, Cu²⁺, and Ni²⁺.

Optionally, the B ion includes one or both of Pb²⁺ and Sn²⁺.

In some embodiments, the C ion includes one or more of Cs⁺, Ag⁺, K⁺, and Ru⁺.

In some embodiments, the D ion includes one or more of Bi³⁺, Ni³⁺, Fe³⁺, and Cu³⁺.

In some embodiments, the X ion includes one or more of F⁻, Cl⁻, Br⁻, and I⁻.

Optionally, the X ion includes one or more of Cl⁻, Br⁻, and I⁻.

In some embodiments, a thickness of the perovskite matrix layer is from 100 nm to 1000 nm. For example, the thickness of the perovskite matrix layer may be 100 nm, 200 nm, 300 nm, 400 nm, 500 nm, 600 nm, 700 nm, 800 nm, 900 nm, 1000 nm, or within a range formed by any two of these values. Optionally, the thickness is from 500 nm to 800 nm.

In the present application, the thickness of the perovskite matrix layer has a meaning well-known in the art and may be measured using methods known in the art. For example, measurement may be performed using a micrometer.

The thickness of the perovskite matrix layer being within the above range helps to further promote its light absorption function.

In some embodiments, a chemical composition of the perovskite matrix layer includes a compound ABX₃ or A₂CDX₆, where A ion is a monovalent cation, B ion is a divalent metal cation, C ion and D ion are a monovalent metal cation and a trivalent metal cation, respectively, and X ion is a monovalent anion.

In some embodiments, the A ion includes one or more of an organic cation, Li⁺, Na⁺, K⁺, Rb⁺, and Cs⁺.

In some embodiments, the organic cation includes at least one of an organic amine ion, a formamidinium group, and an imidazolium group.

In some embodiments, the organic amine ion includes at least one of a methylamine group, an ethylamine group, a propylamine group, a butylamine group, a pentylamine group, and a hexylamine group.

Optionally, the A ion includes one or more of an organic amine ion and Cs⁺.

In some embodiments, the B ion includes one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, Cu²⁺, and Ni²⁺.

Optionally, the B ion includes one or both of Pb²⁺ and Sn²⁺.

In some embodiments, the C ion includes one or more of Cs⁺, Ag⁺, K⁺, and Ru⁺.

In some embodiments, the D ion includes one or more of Bi³⁺, Ni³⁺, Fe³⁺, and Cu³⁺.

In some embodiments, the X ion includes one or more of F⁻, Cl⁻, Br⁻, and I⁻.

Optionally, the X ion includes one or more of Cl⁻, Br⁻, and I⁻.

In some embodiments, the chemical composition of the perovskite matrix layer includes an organic halide CsₓFA_{y}MA_{z}PbI₃, where x+y+z=1, 0<x<0.05, 0.8≤y≤0.95, and 0≤z≤0.1.

According to a second aspect, the present application provides a preparation method of the perovskite film according to the first aspect of the present application, including the following steps:
S10: Prepare a perovskite matrix layer on a support layer.
S20: Enable an ammonium salt solution to come into contact with a surface of the perovskite matrix layer and perform a first annealing treatment to form a plurality of spaced-apart nano-protrusions on the surface of the perovskite matrix layer, forming a perovskite composite, and obtaining the perovskite film.

Without intending to be limited by any theory, the inventors speculate that after the ammonium salt solution is enabled to come into contact with the surface of the perovskite matrix layer, the ammonium salt may interact with chemical compositions in the perovskite matrix layer to form zero-dimensional perovskite, and the zero-dimensional perovskite may serve as growth nuclei for the nano-protrusions. During the subsequent first annealing treatment, growth proceeds with these nuclei in an island growth mode, thereby forming a plurality of spaced-apart nano-protrusions in situ on the surface of the perovskite matrix layer.

Thus, the method provided by the present application enables preparation of nano-protrusions through a simple chemical reaction between the ammonium salt and the perovskite matrix layer and a simple annealing treatment, without requiring the introduction of other complex processes (such as mask processes), thereby facilitating reduction of process complexity in device manufacturing and significantly lowering production costs in large-scale commercial production.

In some embodiments, the ammonium salt includes a diammonium salt. For example, it may include, but is not limited to, one or more of ethylenediamine, propylenediamine, butylenediamine, and p-phenylenediamine. The diammonium salt can interact with chemical compositions (perovskite components) in the perovskite matrix layer to provide growth nuclei for the growth of multiple nano-protrusions.

In some embodiments, a mass concentration of the ammonium salt solution is from 0.05 mg/mL to 1 mg/mL. For example, the mass concentration of the ammonium salt solution may be 0.05 mg/mL, 0.08 mg/mL, 0.1 mg/mL, 0.3 mg/mL, 0.5 mg/mL, 0.8 mg/mL, 1 mg/mL, or within a range formed by any two of these values.

The mass concentration of the ammonium salt solution being within the above range helps to promote a reaction between the ammonium salt and chemical compositions in the perovskite matrix layer to form zero-dimensional perovskite, thereby promoting formation of crystal nuclei.

In some embodiments, a temperature of the first annealing treatment is from 90°C to 120°C. For example, the temperature of the first annealing treatment may be 90°C, 95°C, 100°C, 105°C, 110°C, 115°C, 120°C, or within a range formed by any two of these values.

In some embodiments, a duration of the first annealing treatment is from 5 min to 10 min. For example, the duration of the first annealing treatment may be 5 min, 6 min, 7 min, 8 min, 9 min, 10 min, or within a range formed by any two of these values.

The temperature and duration of the first annealing treatment being within the above ranges help to promote growth of the nano-protrusions in an island growth mode.

In some embodiments, the ammonium salt solution includes a first organic solvent, and the first organic solvent can dissolve the ammonium salt without affecting properties of the perovskite matrix layer. For example, the first organic solvent may include, but is not limited to, one or more of isopropanol, ethanol, ethylene glycol, and glycerol.

In some embodiments, the method further includes the following step S30:
S30: Perform an impurity removal treatment on the perovskite composite to obtain the perovskite film.

In some embodiments, step S30 of performing the impurity removal treatment on the perovskite composite further includes the following step:
S300: Enable a second organic solvent to come into contact with a surface of the perovskite composite and perform a second annealing treatment.

After the formation of the nano-protrusions in step S20, impurities such as unreacted ammonium salt may remain on the surface of the perovskite composite; cleaning the surface of the perovskite composite with the second organic solvent enables relatively complete dissolution of the impurities in the second organic solvent; and subsequently performing the second annealing treatment enables relatively complete removal of the impurities.

In some embodiments, the second solvent may include, but is not limited to, one or more of isopropanol, ethanol, ethylene glycol, and glycerol.

In some embodiments, a temperature of the second annealing treatment is from 90°C to 120°C. For example, the temperature of the second annealing treatment may be 90°C, 95°C, 100°C, 105°C, 110°C, 115°C, 120°C, or within a range formed by any two of these values.

In some embodiments, a duration of the second annealing treatment is from 5 min to 10 min. For example, the duration of the first annealing treatment may be 5 min, 6 min, 7 min, 8 min, 9 min, 10 min, or within a range formed by any two of these values.

The temperature and duration of the second annealing treatment being within the above ranges facilitate relatively complete removal of impurities.

In some embodiments, step S10 of preparing the perovskite matrix layer on the support layer includes the following steps:
S100: Enable a perovskite precursor solution to come into contact with an anti-solvent on the support layer to form a wet film of the perovskite matrix layer.
S110: Perform a third annealing treatment on the wet film of the perovskite matrix layer to obtain the perovskite matrix layer.

In the above preparation steps S100 to S110, treating the perovskite precursor solution with the anti-solvent helps to enhance crystallinity of the perovskite matrix layer at room temperature; and subsequently performing the third annealing treatment helps to further promote crystal growth of the perovskite matrix layer and removal of residual anti-solvent.

In some embodiments, the perovskite precursor solution includes a compound ABX₃ or A₂CDX₆, where A ion is a monovalent cation, B ion is a divalent metal cation, C ion and D ion are a monovalent metal cation and a trivalent metal cation, respectively, and X ion is a monovalent anion.

In some embodiments, the A ion includes one or more of an organic cation, Li⁺, Na⁺, K⁺, Rb⁺, and Cs⁺.

In some embodiments, the organic cation includes at least one of an organic amine ion, a formamidinium group, and an imidazolium group.

In some embodiments, the organic amine ion includes at least one of a methylamine group, an ethylamine group, a propylamine group, a butylamine group, a pentylamine group, and a hexylamine group.

Optionally, the A ion includes one or more of an organic amine ion and Cs⁺.

In some embodiments, the B ion includes one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, Cu²⁺, and Ni²⁺.

Optionally, the B ion includes one or both of Pb²⁺ and Sn²⁺.

In some embodiments, the C ion includes one or more of Cs⁺, Ag⁺, K⁺, and Ru⁺.

In some embodiments, the D ion includes one or more of Bi³⁺, Ni³⁺, Fe³⁺, and Cu³⁺.

In some embodiments, the X ion includes one or more of F⁻, Cl⁻, Br⁻, and I⁻.

Optionally, the X ion includes one or more of Cl⁻, Br⁻, and I⁻.

In some embodiments, the perovskite precursor solution includes an organic halide CsₓFA_{y}MA_{z}PbI₃, where x+y+z=1, 0≤x≤0.05, 0.8≤y≤0.95, and 0<z<0.1.

In some embodiments, a molar concentration of the perovskite precursor solution is from 1 mol/L to 1.8 mol/L. For example, the molar concentration of the perovskite precursor solution may be 1 mol/L, 1.2 mol/L, 1.4 mol/L, 1.6 mol/L, 1.8 mol/L, or within a range formed by any two of these values.

The molar concentration of the perovskite precursor solution being within the above range enables provision of sufficient organic luminescent material for the perovskite matrix layer, thereby providing sufficient photoelectrons, resulting in a relatively high luminescence efficiency (photoelectric conversion efficiency) of the perovskite battery.

In some embodiments, the perovskite precursor solution further includes a third organic solvent, and the third organic solvent may include, but is not limited to, one or more of N,N-dimethylformamide, dimethyl sulfoxide, N-methylpyrrolidone, acetonitrile, 2-mercaptoethanol, and 1-methyl-2-pyrrolidone.

In some embodiments, the anti-solvent promotes crystal growth of the perovskite matrix layer and may include, but is not limited to, one or more of chlorobenzene, anisole, diethyl ether, and ethyl acetate.

In some embodiments, a temperature of the third annealing treatment is from 90°C to 150°C. For example, the temperature of the third annealing treatment may be 90°C, 95°C, 100°C, 105°C, 110°C, 115°C, 120°C, 125°C, 130°C, 135°C, 140°C, 145°C, 150°C, or within a range formed by any two of these values.

In some embodiments, a duration of the third annealing treatment is from 10 min to 40 min. For example, the duration of the third annealing treatment may be 10 min, 20 min, 30 min, 40 min, or within a range formed by any two of these values.

The temperature and duration of the third annealing treatment being within the above ranges help to further promote crystal growth of the perovskite matrix layer and removal of residual anti-solvent.

According to a third aspect, the present application provides a perovskite battery including the perovskite film according to the first aspect of the present application or the perovskite film prepared by the method according to the second aspect of the present application.

In some embodiments, the present application provides a perovskite battery including a first electrode, a second electrode, and the perovskite film according to the first aspect of the present application, where the perovskite film is disposed between the first electrode and the second electrode.

The perovskite film according to the first aspect of the present application serves as a light-absorbing layer in the perovskite battery.

When the perovskite battery operates, the light-absorbing layer, upon illumination, has its internal electrons gain energy and break free from the constraints of the light-absorbing layer, forming negatively charged electron carriers and positively charged hole carriers, thereby generating electron-hole pairs. Free electrons and free holes are transported in opposite directions through corresponding transport layers, causing electrons and holes to flow and form an external current, thus achieving conversion of light energy into electrical energy. Further, after absorbing photons, the light-absorbing layer generates excited electron-hole pairs, and the electron-hole pairs dissociate to form free carriers with opposite charges. Free electrons are transported to a positive electrode through an electron transport layer, and free holes are transported to a negative electrode through a hole transport layer. The two types of free carriers are collected by their respective electrodes, further forming a photocurrent in the circuit of the perovskite battery.

In some embodiments, as shown in FIG. 3, the perovskite battery includes a first electrode layer 10, a perovskite layer 30, a first charge transport layer 40, and a second electrode layer 50 stacked sequentially, the perovskite layer 30 including the aforementioned perovskite film, where the nano-protrusions in the perovskite film face the first charge transport layer 40 along a thickness direction of the perovskite layer 30.

The perovskite battery provided by the present application includes the aforementioned perovskite film, the nano-protrusions in the perovskite film face the first charge transport layer, and thus the nano-protrusions enable point contact at an interface between the perovskite layer and the first charge transport layer, thereby reducing a contact area between the perovskite layer and the first charge transport layer. This reduces occurrence of non-radiative recombination due to interface contact, thus enhancing the open-circuit voltage and photoelectric conversion efficiency of the battery.

In some embodiments, the first charge transport layer 40 includes a first charge transport matrix layer 410 and a filler 420 disposed on a surface of the first charge transport matrix layer, the filler 420 extending along a thickness direction of the first charge transport matrix layer 410 and filling gaps formed by the nano-protrusions 320.

It can be understood that the filler is automatically formed by filling the gaps formed by the multiple nano-protrusions on the perovskite layer during preparation of the first charge transport layer on the perovskite layer after the perovskite layer is prepared.

The first charge transport layer includes the filler formed by filling gaps formed by the nano-protrusions, and the filler can achieve point contact between the first charge transport layer and the perovskite layer. By controlling the spacing distance between the nano-protrusions, a number of gaps formed by the nano-protrusions per unit area of the perovskite layer can be controlled, thereby controlling a density of the filler. By controlling the density of the filler, a filling amount of the first charge transport layer can be controlled, thereby controlling a contact area between the first charge transport layer and the perovskite layer, sufficiently reducing occurrence of non-radiative recombination between the two, and effectively enhancing the open-circuit voltage and photoelectric conversion efficiency of the battery.

In some embodiments, the first charge transport matrix layer and the filler have the same chemical composition.

In some embodiments, the first charge transport layer includes an electron transport layer.

When the first charge transport layer includes an electron transport layer, the nano-protrusions in the perovskite layer can reduce a contact interface between the perovskite layer and the electron transport layer, reducing non-radiative recombination of holes on the surface of the perovskite layer with electrons in the electron transport layer due to interface defects, thereby enhancing the photoelectric conversion efficiency of the battery.

In some embodiments, as shown in FIG. 4, the perovskite battery may include a first electrode layer 10, a second charge transport layer 20, a perovskite layer 30, a first charge transport layer 40, and a second electrode layer 50 stacked sequentially, the second charge transport layer 20 being disposed between the first electrode layer 10 and the perovskite layer 30.

In some embodiments, the second charge transport layer includes a hole transport layer.

In some embodiments, the perovskite battery may include a first electrode layer, a perovskite layer, an electron transport layer, and a second electrode layer stacked sequentially.

In some embodiments, the perovskite battery may include a first electrode layer, a perovskite layer, a hole transport layer, and a second electrode layer stacked sequentially.

In some embodiments, the perovskite battery may include a first electrode layer, an electron transport layer, a perovskite layer, a hole transport layer, and a second electrode layer stacked sequentially.

The electron transport layer can extract and transport electron carriers and block free holes from passing through.

The hole transport layer can extract and transport hole carriers and block free electrons from passing through.

It can be understood that the perovskite battery includes two electrodes, namely a first electrode and a second electrode, one of which serves as a positive electrode to collect electron carriers transported via the electron transport layer, and the other serves as a negative electrode to collect hole carriers transported via the hole transport layer.

In some embodiments, materials for the electron transport layer may include, but are not limited to, one or more of the following materials and their derivatives: imide compounds, quinone compounds, fullerene and its derivatives, methoxy triphenylamine-formamidinium (OMeTPA-FA), calcium titanate (CaTiO₃), lithium fluoride (LiF), calcium fluoride (CaF₂), poly(3,4-ethylenedioxythiophene):polystyrenesulfonate (PEDOT:PSS), poly(3-hexylthiophene) (P3HT), triphenylene-based triphenylamine (H101), 3,4-ethylenedioxythiophene-methoxy triphenylamine (EDOT-OMeTPA), N-(4-aniline)carbazole-spirobifluorene (Cz)localhostAF-SBF), polythiophene, metal oxides, silicon oxide (SiO₂), strontium titanate (SrTiO₃), copper thiocyanate (CuSCN), and the like; where the metal element may include one or more of Mg, Ni, Cd, Zn, In, Pb, Mo, W, Sb, Bi, Cu, Hg, Ti, Ag, Mn, Fe, V, Sn, Zr, Sr, Ga, and Cr.

In some embodiments, the hole transport layer may include, but is not limited to, one or more of the following materials and their derivatives: 2,2',7,7'-tetrakis[N,N-di(4-methoxyphenyl)amino]-9,9'-spirobifluorene (Spiro-OMeTAD), polytriarylamine (PTAA), nickel oxide (NiOₓ), poly(3,4-ethylenedioxythiophene):poly(styrenesulfonate) (PEDOT:PSS), WO₃, and other materials capable of transporting holes and blocking electrons.

In some embodiments, one of the "first charge transport layer" and "second charge transport layer" is an electron transport layer, and the other is a hole transport layer. In some embodiments, the first charge transport layer is an electron transport layer. In some embodiments, the first charge transport layer is a hole transport layer.

In some embodiments, one of the "first electrode" and "second electrode" is a transparent electrode for light incidence. In some embodiments, the first electrode is a transparent electrode.

In some embodiments, materials for the transparent electrode may include, but are not limited to, one or more of the following materials: fluorine-doped tin oxide (FTO), tin-doped indium oxide (ITO), aluminum-doped zinc oxide (AZO), boron-doped zinc oxide (BZO), indium zinc oxide (IZO), tungsten-doped indium oxide (IWO), and the like.

In some embodiments, the second electrode includes a conductive material. Further, the conductive material may be an organic conductive material, an inorganic conductive material, or a combination thereof. Non-limiting examples of inorganic conductive materials include metallic conductive materials. Further, the metallic conductive materials may include any one of gold (Au), silver (Ag), copper (Cu), aluminum (Al), nickel (Ni), chromium (Cr), bismuth (Bi), platinum (Pt), magnesium (Mg), or any suitable mixture of the foregoing elements. The conductive material may include a conductive oxide. Further, the conductive material may be a conductive oxide; and non-limiting examples of conductive oxides may include one or more of FTO, ITO, IWO, AZO, and the like.

In some embodiments, the perovskite battery may include a transparent electrode, a perovskite layer, an electron transport layer, and a second electrode layer stacked sequentially.

In some embodiments, the perovskite battery may include a transparent electrode, a perovskite layer, a hole transport layer, and a second electrode layer stacked sequentially.

In some embodiments, the perovskite battery may include a transparent electrode, a hole transport layer, a perovskite layer, an electron transport layer, and a second electrode layer stacked sequentially.

In some embodiments, the perovskite battery may include a transparent electrode, an electron transport layer, a perovskite layer, a hole transport layer, and a second electrode layer stacked sequentially.

In some embodiments, the perovskite battery is either an inverted p-i-n battery or a regular n-i-p battery.

The perovskite battery provided by the present application may include both regular and inverted configurations.

For the regular configuration, the perovskite battery includes a transparent electrode and an electron transport layer, a perovskite layer, a hole transport layer, and a second electrode layer stacked sequentially on the transparent electrode.

For the inverted configuration, the perovskite battery includes a transparent electrode and a hole transport layer, a perovskite layer, an electron transport layer, and a second electrode layer stacked sequentially on the transparent electrode. The transparent electrode is used for light incidence.

In some embodiments, the perovskite battery includes the following structure arranged sequentially: a substrate layer (which may be a glass substrate or a flexible substrate), a first electrode, a hole transport layer, a perovskite layer, an electron transport layer, and a second electrode. The flexible substrate may include one or more materials such as polyethylene terephthalate, polyimide, polyethylene, polypropylene, polystyrene, and polyethylene naphthalate. Optionally, the first electrode is a transparent electrode for light incidence.

In some embodiments, the perovskite battery includes the following structure arranged sequentially: a substrate layer (glass substrate or flexible substrate), a first electrode, an electron transport layer, a perovskite layer, a hole transport layer, and a second electrode. Optionally, the first electrode is a transparent electrode for light incidence. The definition of the flexible substrate can refer to the foregoing.

In the embodiments of the present application, the substrate layer involved may be, but is not limited to, a glass substrate or a flexible substrate.

In some embodiments, the substrate layer is a flexible substrate layer. Further, the material of the substrate layer may include, for example (but not limited to), organic polymer materials. Further, the material of the substrate layer may be a mixture of one or more of the following materials in different proportions: including but not limited to polyvinyl alcohol (PVA), polyester (PET), polyimide (PI), polyethylene naphthalate (PEN), and polydimethylsiloxane (PDMS).

In the present application, the specifications of the perovskite battery are not particularly limited and may be, but are not limited to, 300 millimeters (mm) × 300 mm.

It can be understood that the structure of the perovskite battery involved in the present application is not limited to the structural layers listed above. Other functional layers, such as a buffer layer, may also be introduced as needed. In some embodiments, the perovskite battery may include a buffer layer with suitable energy levels, which can reduce energy level barriers, promote energy level matching, improve carrier extraction efficiency, and simultaneously serve one or more functions such as passivating interface defect states, protecting the light-absorbing layer, suppressing oxidative decomposition of the battery by water molecules and oxygen, improving photoelectric conversion efficiency, and enhancing the stability of the perovskite battery. Depending on the position of the buffer layer, the types of buffer layers may include a buffer layer between the hole transport layer and the anode, a buffer layer between the electron transport layer and the cathode, a buffer layer between the hole transport layer and the absorbing layer, and a buffer layer between the electron transport layer and the absorbing layer. Materials that can be used for the buffer layer in the perovskite battery may include, but are not limited to: Cu₂O, NiO, AZO, and TiO₂.

According to a fourth aspect, the present application provides an electric apparatus including the perovskite battery according to the third aspect of the present invention.

In some embodiments, the perovskite battery may be used as a power generation apparatus for the electric apparatus. The type of power generation apparatus may include, but is not limited to, integrated power generation. The position of the power generation apparatus may include, but is not limited to, the roof or back panel of a vehicle.

Further, the electric apparatus may include mobile devices such as mobile phones and laptops, electric vehicles, electric trains, ships, satellites, and power generation systems, but is not limited thereto.

FIG. 5 shows an electric apparatus as an example. The electric apparatus is a vehicle, further, it may be a pure electric vehicle, a hybrid electric vehicle, or a plug-in hybrid electric vehicle, and the like.

As another example, the electric apparatus may be a mobile phone, tablet computer, laptop, calculator, or the like.

As another example, the electric apparatus may be a wearable device, such as a watch.

### Examples

The following describes some examples of the present application. The examples described below are illustrative and used only for explaining the present application, and cannot be construed as limitations on the present application. Examples with no technology or condition specified are made in accordance with the foregoing descriptions, in accordance with technologies or conditions described in literature in the art, or in accordance with product instructions. Reagents or instruments used without indicating the manufacturer are conventional products that are commercially available or can be synthesized in a conventional manner from commercially available products.

In the following examples, "room temperature" refers to 20°C to 30°C, further, it may be 25°C.

### Example 1

The perovskite battery prepared in Example 1 adopted an inverted p-i-n structure.

### (1) Preparation of first electrode

A fluorine-doped SnO₂ (FTO) conductive glass with a size of 5 centimeters (cm) × 5 cm was taken, and an insulating region was left after laser etching. The glass was sequentially ultrasonically cleaned with deionized water, detergent, ethanol, isopropanol, acetone, ethanol, and deionized water for 20 min each, and then dried with N₂ for use as the first electrode.

### (2) Preparation of hole transport layer

A transparent conductive glass was spin-coated with a NiOₓ (where Ni might be Ni²⁺ or Ni³⁺) nanoparticle solution (with a mass concentration of 5 mg/mL) at a speed of 3000 rpm for 40 seconds (s), followed by annealing at 150°C for 15 min. Then, the NiOₓ was spin-coated with a carbazole phosphate (AEMD) solution (with a mass concentration of 0.3 mg/mL) at a speed of 5000 rpm for 30 s, followed by annealing at 100°C for 10 min, and naturally cooled to obtain a hole transport layer with a thickness of approximately 15 nm, which was used as a second charge transport layer.

### (3) Preparation of perovskite layer

### (i) Preparation of perovskite precursor layer

The hole transport layer was first spin-coated with a perovskite precursor solution (a perovskite precursor component was Cs_{0.05}FA_{0.85}MA_{0.1}PbI₃, with a molar concentration of 1.5 mg/mL) at a speed of 1000 revolutions per minute (rpm) for 10 s. A second spin-coating was performed at a speed of 5000 rpm for 30 s. During the second spin-coating process, 200 microliters (µL) of chlorobenzene anti-solvent was dropped at the 20th second.

Subsequently, annealing was performed at 100°C, and after cooling to room temperature, a perovskite matrix layer with a thickness of approximately 800 nm was obtained.

### (ii) Preparation of nano-protrusions

The perovskite matrix layer was further spin-coated with an ammonium salt solution (the ammonium salt solution was prepared by dissolving ethylenediamine salt in isopropanol solvent to a mass concentration of 0.1 mg/mL) at a speed of 5000 rpm for 30 s, followed by annealing at 100°C for 10 min.

After cooling, pure isopropanol solvent was used for spin-coating at a speed of 5000 rpm for 30s; followed by annealing at 100°C for 5 min to obtain multiple nano-protrusions, obtaining the perovskite film, thus forming a perovskite layer.

### (4) Preparation of component electron transport layer

The prepared perovskite layer was placed in a vacuum thermal evaporation device, evacuated to 4×10⁻⁴ Pascals (Pa), and 30 nm of C₆₀ and 7 nm of BCP (bathocuproine) were deposited to obtain the electron transport layer, which was used as a first charge transport layer.

### (5) Preparation of second electrode

By using a thermal evaporation method, a Cu counter electrode was deposited on the electron transport layer using a specific patterned mask to form the second electrode with a thickness of approximately 100 nm, obtaining a perovskite battery.

### Examples 2 to 24

The preparation methods of the perovskite film and perovskite battery in Examples 2 to 24 were similar to those in Example 1, with the difference being that relevant parameters in the preparation process of the perovskite film were adjusted, as detailed in Table 1 below, where "/" indicates the absence of the corresponding parameter.

### Comparative Example 1

The preparation methods of the perovskite film and perovskite battery in Comparative Example 1 were similar to those in Example 1, with the difference being that in step (ii) above, a pure isopropanol solvent with the same mass concentration was used instead of the ammonium salt solution.

### Comparative Example 2

The preparation methods of the perovskite film and perovskite battery in Comparative Example 2 were similar to those in Example 1, with the difference being that step (ii) in step (3) above was omitted.

**Table 1**

| | Preparation of perovskite layer | | | | | | | | Perovskite layer | | | First charge transport layer |
|---|---|---|---|---|---|---|---|---|---|---|---|---|
| | Preparation of perovskite matrix layer | | | Preparation of nano-protrusions | | | | | Perov skite matrix layer | Nano-protrusions | | Positional relationship between nano-protrusions and first charge transport layer |
| | Perovskite precursor solution | | Anti-solvent type | Ammonium salt solution | | Preparation condition | | Whet her impur ity remov al treatm ent was perfor med on perov skite comp osite | Thick ness (nm) | Aver age parti cle size (nm) | Spacin g distan ce (nm) | |
| | Organic halide type | Molar concent ration (mol/L) | | Ammonium salt type | Mass concent ration (mg/mL) | First anneali ng treatm ent temper ature (°C) | First annea ling treat ment durati on (min) | | | | | |
| Example 1 | Cs_{0.05}FA_{0.85}MA_{0.1 0}PbI₃ | 1.5 | Chlorobe nzene | Ethylenedia mine | 0.5 | 100 | 10 | Yes | 800 | 10 | 100-500 | Facing the first charge transport layer along a thickness direction |
| Example 2 | (Cs_{0.05}FA_{0.85}MA_{0. 10})₂RuCuI₆ | 1.5 | Chlorobe nzene | Ethylenedia mine | 0.5 | 100 | 10 | Yes | 800 | 10 | 100-500 | Facing the first charge transport layer along a thickness direction |
| Example 3 | Cs_{0.05}FA_{0.85}MA_{0.1 0}PbI₃ | 1 | Chlorobe nzene | Ethylenedia mine | 0.5 | 100 | 10 | Yes | 800 | 10 | 100-500 | Facing the first charge transport layer along a thickness direction |
| Example 4 | Cs_{0.05}FA_{0.85}MA_{0.1 0}PbI₃ | 1.8 | Chlorobe nzene | Ethylenedia mine | 0.5 | 100 | 10 | Yes | 800 | 10 | 100-500 | Facing the first charge transport layer along a thickness direction |
| Example 5 | Cs_{0.05}FA_{0.85}MA_{0.10}PbI₃ | 1.5 | Anisole | Ethylenedia mine | 0.5 | 100 | 10 | Yes | 800 | 10 | 100-500 | Facing the first charge transport layer along a thickness direction |
| Example 6 | Cs_{0.05}FA_{0.85}MA_{0.1 0}PbI₃ | 1.5 | Chlorobe nzene | p-phenylenedi amine | 0.5 | 100 | 10 | Yes | 800 | 20 | 100-500 | Facing the first charge transport layer along a thickness direction |
| Example 7 | Cs_{0.05}FA_{0.85}MA_{0.1 0}PbI₃ | 1.5 | Chlorobe nzene | Ethylenedia mine | 0.05 | 100 | 10 | Yes | 800 | 10 | 100-500 | Facing the first charge transport layer along a thickness direction |
| Example 8 | CS_{0.05}FA_{0.85}MA_{0.1 0}PbI₃ | 1.5 | Chlorobe nzene | Ethylenedia mine | 0.1 | 100 | 10 | Yes | 800 | 20 | 100-500 | Facing the first charge transport layer along a thickness direction |

| Organic halide type | Molar concent ration (mol/L) | Ammonium salt type | Mass concent ration (mg/mL) (mg/mL) | First anneali ng treatm ent temper ature (°C) | First annea ling treat ment durati on (min) | | | | | | | |
|---|---|---|---|---|---|---|---|---|---|---|---|---|
| Example 9 | Cs_{0.05}FA_{0.85}MA_{0.1 0}PbI₃ | 1.5 | Chlorobe nzene | Ethylenedia mine | 1 | 100 | 10 | Yes | 800 | 30 | 100-500 | Facing the first charge transport layer along a thickness direction |
| Example 10 | Cs_{0.05}FA_{0.85}MA_{0.1 0}PbI₃ | 1.5 | Chlorobe nzene | Ethylenedia mine | 0.02 | 100 | 10 | Yes | 800 | 8 | 100-500 | Facing the first charge transport layer along a thickness direction |
| Example 11 | Cs_{0.05}FA_{0.85}MA_{0.1 0}PbI₃ | 1.5 | Chlorobe nzene | Ethylenedia mine | 1.3 | 100 | 10 | Yes | 800 | 35 | 100-500 | Facing the first charge transport layer along a thickness direction |
| Example 12 | Cs_{0.05}FA_{0.85}MA_{0.1 0}PbI₃ | 1.5 | Chlorobe nzene | Ethylenedia mine | 0.5 | 90 | 10 | Yes | 800 | 9 | 100-500 | Facing the first charge transport layer along a thickness direction |
| Example 13 | Cs_{0.05}FA_{0.85}MA_{0.1 0}PbI₃ | 1.5 | Chlorobe nzene | Ethylenedia mine | 0.5 | 120 | 10 | Yes | 800 | 13 | 100-500 | Facing the first charge transport layer along a thickness direction |
| Example 14 | Cs_{0.05}FA_{0.85}MA_{0.1 0}PbI₃ | 1.5 | Chlorobe nzene | Ethylenedia mine | 0.5 | 80 | 10 | Yes | 800 | 5 | 100-500 | Facing the first charge transport layer along a thickness direction |
| Example 15 | Cs_{0.05}FA_{0.85}MA_{0.1 0}PbI₃ | 1.5 | Chlorobe nzene | Ethylenedia mine | 0.5 | 130 | 10 | Yes | 800 | 15 | 100-500 | Facing the first charge transport layer along a thickness direction |

| Organic halide type | Molar concent ration (mol/L) | Ammonium salt type | Mass concent ration (mg/mL) | First anneali ng treatm ent temper ature (°C) | First annea ling treat ment durati on (min) | | | | | | | |
|---|---|---|---|---|---|---|---|---|---|---|---|---|
| Example 16 | Cs_{0.05}FA_{0.85}MA_{0.1 0}PbI₃ | 1.5 | Chlorobe nzene | Ethylenedia mine | 0.5 | 100 | 5 | Yes | 800 | 10 | 100-500 | Facing the first charge transport layer along a thickness direction |
| Example 17 | Cs_{0.05}FA_{0.85}MA_{0.1 0}PbI₃ | 1.5 | Chlorobe nzene | Ethylenedia mine | 0.5 | 100 | 10 | Yes | 800 | 10 | 100-500 | Facing the first charge transport layer along a thickness direction |
| Example 18 | CS_{0.05}FA_{0.85}MA_{0.1 0}PbI₃ | 1.5 | Chlorobe nzene | Ethylenedia mine | 0.5 | 100 | 3 | Yes | 800 | 10 | 100-500 | Facing the first charge transport layer along a thickness direction |
| Example 19 | Cs_{0.05}FA_{0.85}MA_{0.1} osFAo.₈₅MAo._{1 0}PbI₃ | 1.5 | Chlorobe nzene | Ethylenedia mine | 0.5 | 100 | 15 | Yes | 800 | 10 | 100-500 | Facing the first charge transport layer along a thickness direction |
| Example 20 | Cs_{0.05}FA_{0.85}MA_{0.1 0}PbI₃ | 1.5 | Chlorobe nzene | Ethylenedia mine | 0.5 | 100 | 10 | No | 800 | 10 | 500-1000 | Facing the first charge transport layer along a thickness direction |
| Example 21 | CS_{0.05}FA_{0.85}MA_{0.1 0}PbI₃ | 1.5 | Chlorobe nzene | Ethylenedia mine | 0.5 | 100 | 10 | Yes | 800 | 10 | 100-500 | Facing away from the first charge transport layer along a thickness direction |
| Example 22 | Cs_{0.05}FA_{0.85}MA_{0.1 0}PbI₃ | 1.5 | Chlorobe nzene | Ethylenedia mine | 0.5 | 100 | 10 | Yes | 800 | 10 | 2-10 | Facing the first charge transport layer along a thickness direction |
| Example 23 | Cs_{0.05}FA_{0.85}MA_{0.1 0}PbI₃ | 1.5 | Chlorobe nzene | Ethylenedia mine | 0.5 | 100 | 10 | Yes | 800 | 10 | 10-100 | Facing the first charge transport layer along a thickness direction |
| Example 24 | Cs_{0.05}FA_{0.85}MA_{0.1 0}PbI₃ | 1.5 | Chlorobe nzene | Ethylenedia mine | 0.5 | 100 | 10 | Yes | 800 | 10 | 1000-1500 | Facing the first charge transport layer along a thickness direction |
| Comparative Example 1 | Cs_{0.05}FA_{0.85}MA_{0.1 0}PbI₃ | 1.5 | Chlorobe nzene | Isopropanol | 0.5 | 100 | 10 | Yes | 800 | / | / | Facing the first charge transport layer along a thickness direction |
| Comparative Example 2 | Cs_{0.05}FA_{0.85}MA_{0.1 0}PbI₃ | 1.5 | Chlorobe nzene | / | / | / | / | / | 800 | / | / | / |

Additionally, performance tests were conducted on the perovskite films and perovskite batteries in Examples 1 to 24 and Comparative Examples 1 and 2, with the results shown in Table 2 below.

### Test methods

### (1) Surface morphology test

The surface morphology of the perovskite film was tested using a scanning electron microscope (model: Hitachi, HD-2700).

### (2) Photoelectric conversion efficiency test

Under standard simulated sunlight (with AM 1.5G, 100 mW/cm²) at room temperature and atmospheric pressure, battery performance was tested to obtain an I-V curve (volt-ampere characteristic curve). Based on the I-V curve and data feedback from the testing equipment (four-channel digital source meter, Keithley 2440), the short-circuit current density Jsc (in milliamperes per square centimeter, mA/cm²), open-circuit voltage Voc (in volts, V), maximum light output current Jmpp (in milliamperes, mA), and maximum light output voltage Vmpp (in volts, V) were obtained.

The fill factor FF (in %) was calculated using the formula FF = Jsc × Voc / (Jmpp × Vmpp). The photoelectric conversion efficiency PCE in % was calculated using the formula PCE = Jsc × Voc × FF / Pw, where Pw represents the input power (in milliwatts, mW).

"Room temperature and atmospheric pressure" refers to atmospheric pressure at a temperature of 25°C; and room temperature refers to 20°C to 30°C, further, it may be 25°C.

**Table 2**

| | Open-circuit voltage (V) | Photoelectric conversion efficiency (%) |
|---|---|---|
| Example 1 | 1.162 | 24.3 |
| Example 2 | 1.143 | 23.9 |
| Example 3 | 1.155 | 24.2 |
| Example 4 | 1.133 | 23.7 |
| Example 5 | 1.146 | 24.0 |
| Example 6 | 1.139 | 23.5 |
| Example 7 | 1.161 | 24.5 |
| Example 8 | 1.123 | 23.1 |
| Example 9 | 1.145 | 23.9 |
| Example 10 | 1.147 | 23.7 |
| Example 11 | 1.128 | 22.8 |
| Example 12 | 1.132 | 23.2 |
| Example 13 | 1.151 | 23.6 |
| Example 14 | 1.140 | 23.3 |
| Example 15 | 1.136 | 23.7 |
| Example 16 | 1.129 | 22.9 |
| Example 17 | 1.155 | 24.0 |
| Example 18 | 1.138 | 23.6 |
| Example 19 | 1.146 | 24.3 |
| Example 20 | 1.130 | 23.5 |
| Example 21 | 1.128 | 22.8 |
| Example 22 | 1.127 | 22.5 |
| Example 23 | 1.129 | 22.6 |
| Example 24 | 1.115 | 22.1 |
| Comparative Example 1 | 1.112 | 22.0 |
| Comparative Example 2 | 1.093 | 21.4 |

In Table 2 above, by comparing the examples with Comparative Example 1, it can be seen that the open-circuit voltage and photoelectric conversion efficiency of the Examples are higher than those of Comparative Example 1, indicating that a pure isopropanol solvent cannot form nano-protrusions. Comparing the examples with Comparative Example 2, it can be seen that the open-circuit voltage and photoelectric conversion efficiency of the Examples are higher than those of Comparative Example 2, indicating that the nano-protrusions provided on the perovskite layer in the present application can enhance the open-circuit voltage and photoelectric conversion efficiency of the battery.

The technical features of the above-described embodiments can be arbitrarily combined. For brevity, not all possible combinations of the technical features in the above embodiments are described. However, as long as there is no contradiction in the combination of these technical features, they should be considered within the scope of this specification.

It should be noted that the present application is not limited to the foregoing embodiments. The above embodiments are merely examples, and embodiments having substantially the same configuration and achieving the same effects as the technical ideas within the scope of the technical solutions of the present application are included in the technical scope of the present application. The above embodiments only express several implementations of the present application, and their descriptions are relatively detailed, but they should not be construed as limiting the scope of the patent. In addition, without departing from the essence of the present application, various modifications that can be conceived by those skilled in the art and other configurations formed by combining some of the constituent elements in the embodiments are also included in the scope of the present application. It should be pointed out that, for those of ordinary skill in the art, several variations and improvements can be made without departing from the concept of the present application, and these fall within the protection scope of the present application. Therefore, the protection scope of the present application should be subject to the appended claims, and the specification and the accompanying drawings may be used to explain the contents of the claims.

## Claims

1. A perovskite film comprising:
a perovskite matrix layer; and
a plurality of spaced-apart nano-protrusions disposed on at least one surface of the perovskite matrix layer.

2. The perovskite film according to claim 1, wherein an average particle size of the nano-protrusions is from 1 nm to 10 nm, optionally from 1 nm to 5 nm.

3. The perovskite film according to claim 1 or 2, wherein a spacing distance between center points of two adjacent nano-protrusions is from 2 nm to 1 µm, optionally from 10 nm to 0.5 µm.

4. The perovskite film according to any one of claims 1 to 3, wherein the nano-protrusions satisfy at least one of the following conditions:
(1) the nano-protrusions have an irregular columnar morphology; and
(2) a chemical composition of the nano-protrusions comprises LₘAₙ₋₁BₙX₃ₙ₊₁, wherein 1 ≤ m < 2, n ≥ 1 and is an integer, L ion is NH₄⁺, A ion is a monovalent cation, B ion is a divalent metal cation, C ion and D ion are a monovalent metal cation and a trivalent metal cation, respectively, and X ion is a monovalent anion;
the A ion comprises one or more of an organic cation, Li⁺, Na⁺, K⁺, Rb⁺, and Cs⁺;
optionally, the organic cation comprises at least one of an organic amine ion, a formamidinium group, and an imidazolium group;
further optionally, the organic amine ion comprises at least one of a methylamine group, an ethylamine group, a propylamine group, a butylamine group, a pentylamine group, and a hexylamine group;
optionally, the A ion comprises one or more of an organic amine ion and Cs⁺;
the B ion comprises one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, Cu²⁺, and Ni²⁺;
optionally, the B ion comprises one or both of Pb²⁺ and Sn²⁺;
the C ion comprises one or more of Cs⁺, Ag⁺, K⁺, and Ru⁺;
the D ion comprises one or more of Bi³⁺, Ni³⁺, Fe³⁺, and Cu³⁺;
the X ion comprises one or more of F⁻, Cl⁻, Br⁻, and I⁻; and
optionally, the X ion comprises one or more of Cl⁻, Br, and I⁻.

5. The perovskite film according to any one of claims 1 to 4, wherein the perovskite matrix layer satisfies at least one of the following conditions:
(1) a thickness of the perovskite matrix layer is from 100 nm to 1000 nm, optionally from 500 nm to 800 nm; and
(2) a chemical composition of the perovskite matrix layer comprises a compound ABX₃ or A₂CDX₆, wherein A ion is a monovalent cation, B ion is a divalent metal cation, C ion and D ion are a monovalent metal cation and a trivalent metal cation, respectively, and X ion is a monovalent anion;
the A ion comprises one or more of an organic cation, Li⁺, Na⁺, K⁺, Rb⁺, and Cs⁺;
optionally, the organic cation comprises at least one of an organic amine ion, a formamidinium group, and an imidazolium group;
further optionally, the organic amine ion comprises at least one of a methylamine group, an ethylamine group, a propylamine group, a butylamine group, a pentylamine group, and a hexylamine group;
optionally, the A ion comprises one or more of an organic amine ion and Cs⁺;
the B ion comprises one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, Cu²⁺, and Ni²⁺;
optionally, the B ion comprises one or both of Pb²⁺ and Sn²⁺;
the C ion comprises one or more of Cs⁺, Ag⁺, K⁺, and Ru⁺;
the D ion comprises one or more of Bi³⁺, Ni³⁺, Fe³⁺, and Cu³⁺;
the X ion comprises one or more of F⁻, Cl⁻, Br⁻, and I⁻;
optionally, the X ion comprises one or more of Cl⁻, Br, and I⁻; and
optionally, the chemical composition of the perovskite matrix layer comprises an organic halide CsₓFA_{y}MA_{z}PbI₃, wherein x+y+z=1, 0≤x≤0.05, 0.8≤y≤0.95, and 0<z<0.1.

6. A preparation method of a perovskite film, comprising:
preparing a perovskite matrix layer on a support layer; and
enabling an ammonium salt solution to come into contact with a surface of the perovskite matrix layer and performing a first annealing treatment to form a plurality of spaced-apart nano-protrusions on the surface of the perovskite matrix layer, forming a perovskite composite, thereby obtaining the perovskite film.

7. The method according to claim 6, wherein the ammonium salt solution satisfies at least one of the following conditions:
(1) a mass concentration of the ammonium salt solution is from 0.05 mg/mL to 1 mg/mL;
(2) the ammonium salt comprises one or more of ethylenediamine, propylenediamine, butylenediamine, and p-phenylenediamine; and
(3) the ammonium salt solution comprises a first organic solvent, the first organic solvent comprising one or more of isopropanol, ethanol, ethylene glycol, and glycerol.

8. The method according to claim 6 or 7, wherein the first annealing treatment satisfies at least one of the following conditions:
(1) a temperature of the first annealing treatment is from 90°C to 120°C; and
(2) a duration of the first annealing treatment is from 5 min to 10 min.

9. The method according to any one of claims 6 to 8, further comprising: performing an impurity removal treatment on the perovskite composite.

10. The method according to claim 9, wherein the step of performing the impurity removal treatment on the perovskite composite comprises:
enabling a second organic solvent to come into contact with a surface of the perovskite composite and performing a second annealing treatment;
optionally, the second organic solvent comprises one or more of isopropanol, ethanol, ethylene glycol, and glycerol;
optionally, a temperature of the second annealing treatment is from 90°C to 120°C; and
optionally, a duration of the second annealing treatment is from 5 min to 10 min.

11. The method according to any one of claims 6 to 10, wherein the step of preparing the perovskite matrix layer on the support layer comprises:
enabling a perovskite precursor solution to come into contact with an anti-solvent on the support layer to form a wet film of the perovskite matrix layer; and
performing a third annealing treatment on the wet film of the perovskite matrix layer to obtain the perovskite matrix layer; wherein
optionally, a temperature of the third annealing treatment is from 90°C to 150°C; and
optionally, a duration of the third annealing treatment is from 10 min to 40 min.

12. The method according to claim 11, wherein at least one of the following conditions is satisfied:
(1) the perovskite precursor solution comprises a compound ABX₃ or A₂CDX₆, wherein A ion is a monovalent cation, B ion is a divalent metal cation, C ion and D ion are a monovalent metal cation and a trivalent metal cation, respectively, and X ion is a monovalent anion;
the A ion comprises one or more of an organic cation, Li⁺, Na⁺, K⁺, Rb⁺, and Cs⁺;
optionally, the organic cation comprises at least one of an organic amine ion, a formamidinium group, and an imidazolium group;
further optionally, the organic amine ion comprises at least one of a methylamine group, an ethylamine group, a propylamine group, a butylamine group, a pentylamine group, and a hexylamine group;
optionally, the A ion comprises one or more of an organic amine ion and Cs⁺;
the B ion comprises one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, Cu²⁺, and Ni²⁺;
optionally, the B ion comprises one or both of Pb²⁺ and Sn²⁺;
the C ion comprises one or more of Cs⁺, Ag⁺, K⁺, and Ru⁺;
the D ion comprises one or more of Bi³⁺, Ni³⁺, Fe³⁺, and Cu³⁺;
the X ion comprises one or more of F⁻, Cl⁻, Br⁻, and I⁻;
optionally, the X ion comprises one or more of Cl⁻, Br⁻, and I⁻; and
optionally, the perovskite precursor solution comprises an organic halide CsₓFA_{y}MA_{z}PbI₃, wherein x+y+z=1, 0≤x≤0.05, 0.8≤y≤0.95, and 0≤z≤0.1;
(2) a molar concentration of the perovskite precursor solution is from 1 mol/L to 1.8 mol/L; and
(3) the anti-solvent comprises one or more of chlorobenzene, anisole, diethyl ether, and ethyl acetate.

13. A perovskite battery comprising the perovskite film according to any one of claims 1 to 5 or the perovskite film prepared by the method according to any one of claims 6 to 12.

14. The perovskite battery according to claim 13, comprising a first electrode layer, a perovskite layer, a first charge transport layer, and a second electrode layer stacked sequentially, the perovskite layer comprising the perovskite film, wherein the nano-protrusions in the perovskite film face the first charge transport layer along a thickness direction of the perovskite layer.

15. The perovskite battery according to claim 14, wherein the first charge transport layer comprises a first charge transport matrix layer and a filler disposed on a surface of the first charge transport matrix layer, the filler extending along a thickness direction of the first charge transport matrix layer and filling gaps formed by the nano-protrusions;
optionally, the first charge transport layer comprises an electron transport layer; and
optionally, the first charge transport matrix layer and the filler have the same chemical composition.

16. The perovskite battery according to claim 14 or 15, further comprising a second charge transport layer, wherein the second charge transport layer is disposed between the first electrode layer and the perovskite layer; and
optionally, the second charge transport layer comprises a hole transport layer.

17. An electric apparatus comprising the perovskite battery according to any one of claims 13 to 16.
